Europäisches Patentamt

European Patent Office

Office européen des brevets

(11) Publication number: **0 225 592 B1**

# EUROPEAN PATENT SPECIFICATION

(45) Date of publication of patent specification: **06.05.92** (51) Int. Cl.⁵: **H01L 21/20**, H01L 21/263, H01L 21/268

(21) Application number: **86116778.1**

(22) Date of filing: **03.12.86**

(54) **Recrystallizing conductive films.**

(30) Priority: **04.12.85 JP 272677/85**

(43) Date of publication of application:
**16.06.87 Bulletin 87/25**

(45) Publication of the grant of the patent:
**06.05.92 Bulletin 92/19**

(84) Designated Contracting States:
**DE FR GB**

(56) References cited:
**EP-A- 0 071 471**
**EP-A- 0 127 323**

**JOURNAL OF APPLIED PHYSICS, vol. 55, no. 6, part 1, 15th March 1984, pages 1607-1609, American Institute of Physics, New York, US; S. KAWAMURA et al.: "Laser recrystallization of Si over SiO2 with a heat-sink structure"**

**EXTENDED ABSTRACTS, vol. 82-1, May 1982, pages 243-244, abstract no. 150, Pennington, New Jersey, US; S. KAWAMURA et al.: "Laser-induced lateral epitaxial growth of Si over SiO2"**

**IBM TECHNICAL DISCLOSURE BULLETIN, vol. 22, no. 12, May 1980, pages 5473,5474, New York, US; A.B. FOWLER et al.: "Selective laser annealing through quarter- and half-wave coatings"**

(73) Proprietor: **FUJITSU LIMITED**
**1015, Kamikodanaka Nakahara-ku**
**Kawasaki-shi Kanagawa 211(JP)**

(72) Inventor: **Mukai, Ryoichi Fujitsu Ltd. Kosugi Fujitsu Bld.**
**1812-10 Shimonumabe**
**Nakahara-ku Kawasaki-shi Kanagawa 211(JP)**

(74) Representative: **Sunderland, James Harry et al HASELTINE LAKE & CO Hazlitt House 28 Southampton Buildings Chancery Lane London WC2A 1AT(GB)**

## Description

The present invention relates to the recrystallization of conductive material films, including semiconductor films. The present invention finds application in SOI (Silicon on Insulator) technology.

SOI technology has been proposed as a means for providing high-speed and high-voltage semiconductor integrated circuits (ICs) and at present appears to be one of the most promising prospects for the realization of three-dimensional semiconductor integrated circuits.

In SOI technology, a polysilicon film, usually formed on an insulating layer such as a thermally-oxidized layer of a silicon substrate, is recrystallized, so as to end up single crystalline or grain-boundary free, using irradiation by a radiant energy beam such as a laser. To facilitate the transformation of the polysilicon film into a single crystal film, nucleation in the polysilicon film during recrystallization must be controlled so as to be initiated at a single point in a molten region of the polysilicon film. This can be achieved by producing a temperature distribution, in a region to be recrystallized, having a profile which affords the lowest temperature at the center of the region and higher and higher temperatures towards the periphery of the region.

There are many reports concerning methods of establishing such a temperature profile, including "Recrystallization of Si on amorphous substrate by doughnut-shaped cw Ar laser beam" by S. Kawamura et al., Applied Physics Letter 40 (5), p. 394, 1 March 1982. The doughnut-shaped laser beam, for example, produces a temperature profile having a lowest temperature at the position corresponding to the center of the beam. In United States patent application Serial No. 784,607, the present inventor discloses selective recrystallization of a polysilicon film, using an anti-reflective film having apertures formed therein at positions corresponding to regions ultimately to be single-crystalline in the polysilicon film. With the apertures, the anti-reflective film produces a desired temperature profile which affords a lowest temperature at the center of each region corresponding to the apertures. According to this method, any desired portion of a polysilicon film can be transformed into a single crystalline region of a desired size. The methods mentioned above can be categorized as direct-heating-type SOI technology.

In United States Patent 4,543,133, published September 24, 1985, and a report entitled "Single crystalline Si islands on an amorphous insulating layer recrystallized by an indirect laser heating technique for three-dimensional integrated circuits" on pp. 994-996 of Applied Physics Letter 44 (10), 15 May 1984, the present inventor discloses an SOI technology utilizing indirect heating of a polysilicon film. In the disclosure, islands of a polysilicon film and the surrounding substrate region are coated with an energy-absorbing cap layer. The energy-absorbing cap layer is irradiated with a radiant energy beam, such as an argon ion laser beam, to generate heat. Thus, the polysilicon film islands are melted by the heat transferred from the energy-absorbing cap layer by thermal conduction.

In such an indirect heating SOI technology, fluctuations in output power and intensity distribution of the laser beam are buffered by the energy-absorbing cap layer, and hence, stable and uniform heating can be attained. As a result, polysilicon islands can be recrystallized to be grain-boundary-free with improved reproducibility. Further, this indirect heating SOI technology allows the radiant energy beam to be freed from a need to correspond to the optical absorption characteristics of the to-be-recrystallized film such as polysilicon film. It requires only matching between the wavelength of the radiant energy beam, such as a laser beam, and the absorption spectrum of the energy-absorbing cap layer.

However, with the above-mentioned indirect heating SOI technology, the polysilicon film formed on an insulating layer is patterned to provide islands prior to the recrystallization. The size of each island must be large enough to include therein the source and drain regions together with the active region, i.e. channel region, of a transistor.

Generally, it becomes more difficult to establish the above-mentioned desired temperature profile over an island, as the size of the island becomes larger. This means that, in the previous indirect-heating SOI technology, the existence of recrystallized islands which in fact include a grain boundary has a relatively high probability. If, amongst a number of islands on a semiconductor chip, there is an (one) island having a grain boundary extending into the active region thereof (the active region of the device e.g. transistor to be formed in the island) the chip cannot be used for an integrated circuit and thus, the yield of integrated circuit chips based on the indirect-heating SOI technology is decreased.

As thus suggested, it is advantageous that a region to be recrystallized is as small as possible when a desired temperature profile is established therein. Accordingly, it is desirable to selectively recrystallize only a small region, corresponding to an active region of a device, e.g. the channel region of a transistor, and to leave other regions, corresponding to source and drain regions of the transistor, in a polycrystalline state. However, the previous indirect-heating SOI technology is unable to selectively recrystallize only a region as small as a channel region in a polycrystalline island.

According to the present invention there is provided a process of forming a semiconductor device, comprising the successive steps of:-

forming a nonmonocrystalline film of a semiconductor material on a major surface of an insulator;

forming a thermal-conduction-controlling layer over the nonmonocrystalline film, said thermal-conduction-controlling layer having at least one portion of increased thickness defining a region in which the nonmonocrystalline film is to be recrystallized;

forming a cap layer on said thermal-conduction-controlling layer; and

irradiating the cap layer with an energy beam of radiant energy of a wavelength absorbed by said cap layer sufficient to melt said defined region of said nonmonocrystalline film; and

allowing said nonmonocrystalline layer to cool, hence forming a grain-boundary-free recrystallised region in said defined region.

According to the present invention there is also provided a method of recrystallizing a region of a nonmonocrystalline conductive layer, comprising the successive steps of:-

forming a thermal-conduction-controlling layer on said nonmonocrystalline layer, the thermal-conduction-controlling layer having a portion of increased thickness above and defining said region of the nonmonocrystalline conductive layer;

forming a cap layer above said thermal-conduction-controlling layer; and

irradiating said cap layer with an energy beam of a wavelength absorbed by said cap layer such that said region of said nonmonocrystalline layer is melted;

allowing said nonmonocrystalline layer to cool, hence forming a grain-boundary-free recrystallized region in said defined region.

An embodiment of the present invention can provide a method for selectively transforming regions of a polycrystalline film of a conductive material into grain-boundary-free regions, in an indirect-heating SOI environment.

An embodiment of the present invention can provide a process which can improve the yield of integrated circuit devices fabricated based on SOI.

An embodiment of the present invention provides a process comprising steps of: forming a nonmonocrystalline film of a conductive material (for example semiconductor material such as polysilicon) on an insulator; forming a thermal-conduction-controlling layer of silicon dioxide, for example, on the nonmonocrystalline film, the thermal-conduction-controlling layer having thickness selectively increased at each portion thereof corresponding to predefined regions of the nonmonocrystalline film; forming an energy-absorbing cap layer of polysilicon, for example, on the thermal-conduction-controlling layer; and irradiating the energy-absorbing cap layer with an energy beam of radiant energy sufficient to melt and transform the nonmonocrystalline film in the predefined regions to be grain-boundary free by the heat generated in the energy-absorbing cap layer.

Reference is made, by way of example, to the accompanying drawings, in which:-

Fig. 1 is a schematic sectional elevational view illustrating a recrystallization method according to previously proposed indirect-heating SOI technology;

Fig. 2 is a schematic sectional elevational view illustrating a process embodying the present invention; and

Figs. 3A-3G are respective schematic sectional elevational views illustrating steps in a process embodying the present invention.

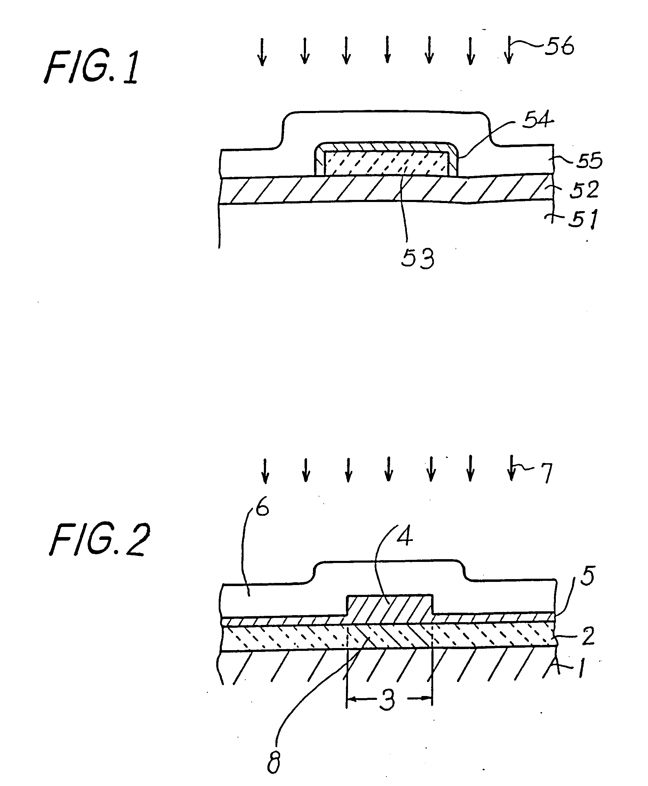

Fig. 1 illustrates a recrystallization method according to a previously proposed indirect-heating SOI technology. In this SOI technology, an insulating film 52 is formed on a silicon substrate 51 and a polysilicon island 53 having a size corresponding to a semiconductor element, such as a transistor, to be fabricated therein is formed on the insulating film 52 through conventional vapour-phase growth and patterning techniques. A separating layer 54 is formed to cover the polysilicon island 53 and then a laser-absorbing layer 55 of polysilicon, for example, is formed on the insulating film 52, having thereon the polysilicon island 53, using a vapour-phase growth technique. The separating layer 54 is for preventing fusion of polysilicon island 53 and laser-absorbing layer 55.

The laser-absorbing layer 55 is irradiated with a radiant energy beam 56, such as an argon (Ar) ion laser beam, having an emission spectrum almost equal to the absorption spectrum of the polysilicon constituting the laser-absorption layer 55. Thus, heat is generated in the laser-absorbing layer 55 and the polysilicon island 53 is heated up, above its melting point, by heat transferred from the laser-absorbing layer 55 by thermal conduction. When the laser beam irradiation 56 is removed, the polysilicon island 53 recrystallizes.

However, grain boundaries sometimes occur in a few out of many thousands of islands, for example, formed on an integrated circuit chip, because each of the islands (such as the island 53) has a size as great as $2 \times 10^{-5}$ m by $6 \times 10^{-5}$ m (20 $\times$ 60 square-microns) in order to contain regions which will provide source and drain of a transistor, and hence, the temperature distribution formed therein is apt to deviate from a desired profile, as mentioned above.

Fig. 2 is a schematic sectional elevational view illustrating an embodiment of the present invention. Referring to Fig. 2, a conductive material film 2, a semiconductor film for example, is formed on an insulating film 1, and then a thermal-conduction-controlling layer (simply referred to as a TCC layer, hereinafter) 5 is formed on the conductive material film 2. The TCC layer 5 has a selectively-increased-thickness portion 4 corresponding to a region 3 at which a portion 8 of the conductive material film 2 is to be transformed so as to be grain-boundary free. Then, an energy-absorbing cap layer 6 is formed on the TCC layer 5 and the energy-absorbing cap layer 6 is irradiated with a radiant energy beam 7. Thus the conductive material film 2 is melted by heat transferred from the energy-absorbing layer 6 and recrystallized.

The TCC layer 5 is usually composed of a material having a thermal conductivity relatively smaller than that of the energy-absorbing cap layer 6, and further, that of the conductive material layer 2.

Heat flowing from the energy-absorbing cap layer 6 to the conductive material film 2 is restricted by the TCC layer 5, particularly in the region 3. Thus, the temperature of the conductive material film 2 is lower in the region 3 than in surrounding regions. However, there is heat flow into the region 3 from surrounding regions, because of the temperature difference arising as described above. Hence, in the region 3, a temperature distribution is established which provides a lowest temperature at the center of the region, with temperature becoming higher and higher towards the periphery of the region.

During the recrystallization of the conductive material film 2, nucleation initiates only at the lowest temperature point in the region 3, and thus, the region 3 is transformed into a grain-boundary-free single-crystalline region. It will be clear that there is substantially no lower limit of the size of the region 3. Therefore, the region can be designed to be as small as the channel region of a transistor. This means that the probability of existence of a grain boundary in the recrystallized region 3 can be substantially decreased compared with that for a recrystallized island 53 provided as illustrated in Fig. 1 in accordance with the previously proposed method.

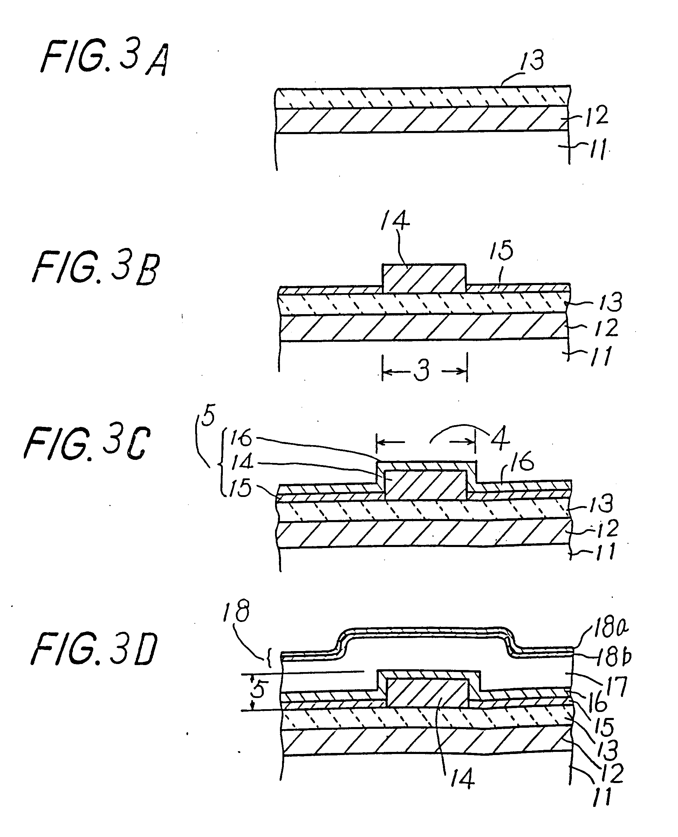

Figs. 3A-3G are respective schematic sectional elevational views illustrating steps in a process embodying the present invention. Like reference signs designate like or corresponding parts throughout.

Referring to Fig. 3A, a relatively thick lower insulating film 12, such as a silicon dioxide (SiO$_2$) film of $1 \times 10^{-6}$ m - $2 \times 10^{-6}$ m (1-2 microns) thickness, is formed on a silicon substrate 11 by thermally oxidizing the substrate, for example. Then, a polysilicon film 13 having a thickness of about 400 nm (4000Å) is formed on the lower insulating film 12 using conventional low-pressure chemical vapour deposition (LP-CVD), for example.

Subsequently, another silicon dioxide (SiO$_2$) layer having a thickness of about 400 nm (4000Å) is formed on the polysilicon film 13 using a conventional CVD method. The SiO$_2$ layer is patterned by a conventional reactive ion etching technique using a not-shown resist mask and etchant, CHF$_3$ gas, for example. Thus a SiO$_2$ layer pattern 14 is selectively formed to cover the polysilicon film 13 in region 3, in which the polysilicon film 13 is to be transformed to be grain-boundary free. The region 3 is defined as (destined to be) an active region, e.g. channel region of a transistor, and has an area of as little as $2 \times 10^{-5}$ m by $2 \times 10^{-5}$ m ($20 \times 20$ square-microns). The exposed surface 4 of the polysilicon film 13 around the SiO$_2$ layer pattern 14 is thermally oxidized so as to form another SiO$_2$ layer 15, of 300A thickness for example, as shown in Fig. 3B.

Referring to Fig. 3C, a silicon nitride (Si$_3$N$_4$) layer 16 having a thickness of 80 nm (800Å) for example, is formed on the SiO$_2$ layer pattern 14 and the SiO$_2$ layer 15 using a conventional CVD technique. The SiO$_2$ layer 15 has the role of preventing chemical reaction between the polysilicon film 13 and the Si$_3$N$_4$ layer 16 at high temperature, and the Si$_3$N$_4$ layer 16 has the role of promoting wetting of a laser absorbing layer of polysilicon, which is formed thereon later, to the substrate.

The SiO$_2$ pattern layer 14, SiO$_2$ layer 15 and Si$_3$N$_4$ layer 16 in all constitute a thermal-conduction-controlling layer 5, and the selectively-increased-thickness region 4 of the TCC layer 5 corresponds to the predefined region 3 in which the polysilicon film 13 is to be transformed to be grain-boundary free.

Following the above, an energy-absorbing layer 17 of polysilicon, for example, of 700 nm (7000Å) thickness is formed on the substrate having the TCC layer 5, using a conventional LP-CVD technique. Further, as an anti-reflective film 18 for a laser beam, a Si$_3$N$_4$ film 18a and a SiO$_2$ film 18b, each having a thickness of about 30 nm (300Å), are successively formed on the polysilicon energy-absorbing layer 17, as shown in Fig. 3D.

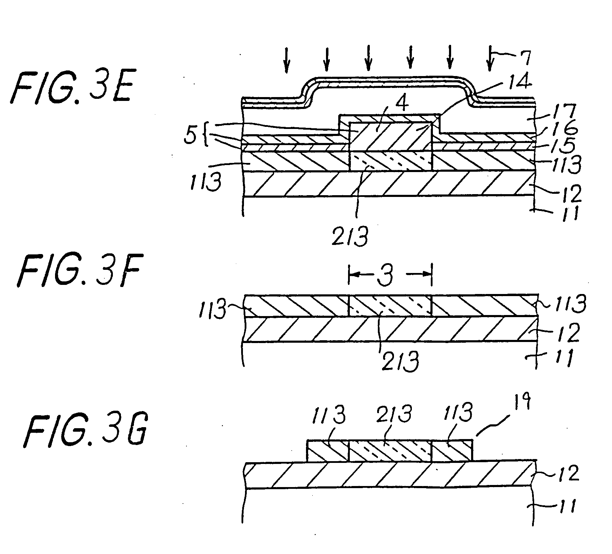

Referring to Fig. 3E, a radiant energy beam 7 is scanned over the polysilicon energy-absorbing layer 17 with preliminary heating applied to the substrate, and thus, the energy-absorbing layer 17 is heated up to a high temperature of about 1500-1600°C. An Ar-ion laser which outputs a beam of 500 nanometer wavelength, for example, is desirably used as the source of the radiant energy beam 7, since silicon reveals strong absorption at this wavelength. The laser beam is tuned so as to provide a Gaussian type intensity distribution in the spot of irradiation provided by the beam. Further, the size of the spot must be large enough to encompass the predefined region of the polysilicon film 13 so that the polysilicon film 13 in the predefined region ($2 \times 10^{-5}$ m by $2 \times 10^{-5}$ m or $20 \times 20$ square-microns) is melted by a single scan of the laser beam 7. Exemplary conditions for the laser beam irradiation are summarized as follows:-

Beam spot size:
$1 \times 10^{-4}$ m (100 microns) in diameter
Intensity of beam:
13-15 Watts
Scanning speed:
2.5 cm/sec
Substrate temperature:
450° C.

With laser beam irradiation under the above conditions, for example, the polysilicon film 13 is melted by the heat transferred from the energy-absorbing layer 17 by conduction via the TCC layer 5. During the laser beam irradiation, the energy-absorbing layer 17 of polysilicon is also melted. In the predefined region, the heat flowing into the polysilicon film 13 under the $SiO_2$ layer pattern 14, i.e. the large-thickness portion 4, of the TCC layer 5 is less at the central portion as compared with that at the peripheral portion, as mentioned before. Thus, a temperature distribution is established in the polysilicon film 13 in the predefined region having a profile providing the lowest temperature at the center with temperature becoming higher towards the periphery. Accordingly, recrystallization of the polysilicon film 13 proceeds to spread from the lowest temperature central portion to the peripheral portion, and thus, a grain boundary-free region 213 is formed in the recrystallized silicon film 113.

Microscopic observation reveals that grain boundaries existing in the recrystallized silicon film 113 extend so as to shun or avoid the region 213, or are stopped at the border of the region 213, and no grain boundary is found in any predefined region 213.

Following the above, the $Si_3N_4$ film 18a and $SiO_2$ film 18b, constituting an anti-reflective layer, are removed using respective conventional etchants; a phosphoric-acid-type solution for the $Si_3N_4$ film 18a and a fluoric-acid-type solution for the $SiO_2$ film 18b, for example. Subsequently, the polysilicon energy-absorbing layer 17 is removed by using a conventional etchant such as a mixture of fluoric acid and nitric acid solutions, and then, the $Si_3N_4$ layer 16 and $SiO_2$ layers 15 and 14 are removed by using respective conventional etchants; a phosphoric acid solution for the $Si_3N_4$ layer 16 and a fluoric acid solution for the $SiO_2$ layers 15

and 14. Thus, the TCC layer 5 is removed and the recrystallized silicon film 113 including the predefined region 213 which has been selectively transformed to be grain-boundary-free is exposed as shown in Fig. 3F.

Referring to Fig. 3G, the recrystallized silicon film 113 is patterned by a conventional RIE (reactive ion etching) technique incorporating a not-shown resist mask and an etchant such as a gas mixture of $CF_4 + O2$, for example, and an island 19 of the recrystallized silicon film 113 including the grain-boundary-free region 213 is formed on the $SiO_2$ lower insulating layer 12. Thus an SOI substrate having a desired number of silicon islands each including a grain-boundary-free region such as the region 213 is completed.

Following the above, a semiconductor circuit element such as a transistor is formed in the silicon island 19, wherein the active region of the element, such as the channel region of a transistor, is allocated in the grain-boundary-free region 213 and source and drain regions of the transistor are fabricated in the recrystallized silicon region 113 around the grain-boundary-free region 213. Thus, an integrated circuit having an SOI structure is provided.

According to this embodiment of the present invention, the recrystallized silicon island 19 has a size of $2 \times 10^{-5}$ m by $6 \times 10^{-5}$ m ($20 \times 60$ square-microns), for example, the same as that of the silicon island 53 shown in Fig. 1 in relation to the previous proposal. However, only a smaller region, such as the active region of a transistor, formed in the island is selectively transformed to be grain-boundary-free. Therefore, the probability of existence of a grain boundary in the active region is substantially decreased, and hence, the yield of SOI ICs can be increased. Further, employing embodiments of the present invention, using indirect-heating SOI technology, the shape of island need not be simple (e.g. rectangular) but can be complicated, for example with the structure of letters C, E, H and so forth, wherein a desired number of active regions can be formed in the structure.

The above embodiment of the present invention relates to the provision of an SOI structure for a semiconductor integrated circuit. However, a recrystallization method embodying the present invention can be applied to a metallized layer of an integrated circuit. That is, a wiring layer such as one formed from amorphous aluminum, fabricated by a vacuum deposition or sputtering technique, for example, can be selectively transformed into a grain-boundary-free aluminum layer. Such a grain-boundary-free wiring layer can eliminate a type of disconnection which occurs in wiring lines for large current load due to existence of grain boundaries therein.

It is to be understood that various modifications of the described embodiments of the present invention can be effected. For example, the SiO$_2$ film 15 and Si$_3$N$_4$ film 16 and the anti-reflective layer 18 shown in Fig. 3D are not essential. Further, the energy-absorbing layer 17 in Fig. 3D, for example, need not be of polysilicon: that layer may be of other materials, provided matching of the wavelengths is established between the emission spectra of the laser beam and the absorption spectra of the energy-absorbing layer, wherein the other materials may have a higher melting point than that of the film to be recrystallized.

An embodiment of the present invention provides a process allowing so-called indirect-heating SOI methodology to selectively transform predefined regions of a semiconductor film formed on an insulating substrate into grain-boundary-free regions. In an indirect-heating SOI, a semiconductor film which is recrystallized to be grain-boundary-free is heated above its melting point by the heat generated in an energy-absorbing layer formed thereon. In an embodiment of the present invention, a layer having a relatively smaller thermal conductivity, such as a SiO$_2$ layer, is provided between the semiconductor film to be recrystallized and the energy-absorbing layer, both having larger thermal conductivities. The smaller-thermal-conductivity layer, functioning as a thermal-resistance, has selectively increased thickness at the portions thereof corresponding to the predefined regions to be transformed to be grain-boundary-free in the semiconductor film. In each of the predefined regions, a desired temperature distribution profile, that is, the lowest temperature at the center of the region and temperature becoming higher towards the periphery of the region, is established, when the energy-absorbing layer is irradiated with a beam of radiant energy sufficient to melt the semiconductor film. Thus, the semiconductor film can be recrystallized to be grain-boundary-free single crystalline in each predefined region.

## Claims

1. A process of forming a semiconductor device, comprising the successive steps of:-

    forming a nonmonocrystalline film (13) of a semiconductor material on a major surface of an insulator (12);

    forming a thermal-conduction-controlling layer (14, 15) over the nonmonocrystalline film (13), said thermal-conduction-controlling layer having at least one portion (14) of increased thickness defining a region in which the nonmonocrystalline film is to be recrystallized;

    forming a cap layer (17) on said thermal-conduction-controlling layer (14, 15); and

    irradiating the cap layer (17) with an energy beam of radiant energy of a wavelength absorbed by said cap layer sufficient to melt said defined region of said nonmonocrystalline film (13); and

    allowing said nonmonocrystalline layer to cool, hence forming a grain-boundary-free recrystallized region (213) in said defined region.

2. A process according to claim 1, wherein the thermal conductivity of said thermal-conduction-controlling layer (14, 15) is smaller than that of said cap layer (17).

3. A process as claimed in claim 1 or 2, wherein said insulator (12) is a film formed on a semiconductor substrate (11).

4. A process as claimed in claim 3, wherein said substrate (11) is of silicon and said insulator (12) is a silicon oxide film formed by oxidizing said silicon substrate.

5. A process as claimed in any preceding claim, further comprising a step of forming an anti-reflective layer on said cap layer (17) prior to said irradiation of said cap layer, said anti-reflective layer reducing reflection of said radiant energy beam incident on the surface of the energy-absorbing cap layer.

6. A process as claimed in any preceding claim, wherein said semiconductor material is polycrystalline silicon, said cap layer (17) is of polycrystalline silicon, and the source of said energy beam is an argon ion laser beam.

7. A process as claimed in any preceding claim, wherein said thermal-conduction-controlling layer (14, 15) is a silicon dioxide layer.

8. A process as claimed in any preceding claim, further comprising a step of forming a wetting layer (16) between said cap layer (17) and said thermal-conduction-controlling layer (14, 15).

9. A process as claimed in claim 8, wherein said wetting layer (16) is formed from silicon nitride.

10. A method of recrystallizing a region of a nonmonocrystalline conductive layer, comprising the successive steps of:-

    forming a thermal-conduction-controlling layer on said nonmonocrystalline layer, the thermal-conduction-controlling layer having a portion of increased thickness above and defining said region of the nonmonocrystalline conductive layer;

forming a cap layer above said thermal-conduction-controlling layer; and

irradiating said cap layer with an energy beam of a wavelength absorbed by said cap layer such that said region of said nonmonocrystalline layer is melted;

allowing said nonmonocrystalline layer to cool, hence forming a grain-boundary-free recrystallized region in said defined region.

11. A method as claimed in claim 10, wherein the nonmonocrystalline conductive layer is of polysilicon.

12. A method as claimed in claim 10, wherein the nonmonocrystalline conductive layer is of amorphous aluminium.

## Revendications

1. Procédé de formation d'un dispositif à semiconducteur, comprenant les opérations successives suivantes :

former une pellicule non monocristalline (13), faite d'un matériau semiconducteur, sur une surface principale d'un isolant (12) ;

former une couche de commande de conduction thermique (14, 15) sur la pellicule non monocristalline (13), ladite couche de commande de conduction thermique comportant au moins une partie (14) à épaisseur accrue qui définit une région dans laquelle la pellicule non monocristalline doit être recristallisée ;

former une couche capuchon (17) sur ladite couche de commande de conduction thermique (14, 15) ;

irradier la couche capuchon (17) à l'aide d'un faisceau énergétique d'énergie rayonnante dont la longueur d'onde est absorbée par ladite couche capuchon à un degré suffisant pour faire fondre ladite région définie de ladite pellicule non monocristalline (13) ; et

laisser refroidir ladite couche non monocristalline, de sorte qu'elle forme une région recristallisée exempte de frontière de grain (213) dans ladite région définie.

2. Procédé selon la revendication 1, où la conductivité thermique de ladite couche de commande de conduction thermique (14, 15) est plus petite que celle de ladite couche capuchon (17).

3. Procédé selon la revendication 1 ou 2, où ledit isolant (12) d'une pellicule est formée sur un substrat semiconducteur (11).

4. Procédé selon la revendication 3, où ledit substrat (11) est fait de silicium et ledit isolant (12) est une pellicule d'oxyde de silicium formée par oxydation dudit substrat de silicium.

5. Procédé selon l'une quelconque des revendications précédentes, comprenant en outre l'opération consistant à former une couche antiréfléchissante sur ladite couche capuchon (17) avant ladite irradiation de ladite couche capuchon, ladite couche antiréfléchissante réduisant la réflexion dudit faisceau d'énergie rayonnante qui tombe sur la surface de la couche capuchon d'absorption d'énergie.

6. Procédé selon l'une quelconque des revendications précédentes, où ledit matériau semiconducteur est du silicium polycristallin, ladite couche capuchon (17) est faite de silicium polycristallin, et la source dudit faisceau d'énergie est un faisceau laser à argon ionisé.

7. Procédé selon l'une quelconque des revendications précédentes, où ladite couche de commande de conduction thermique (14, 15) est une couche de dioxyde de silicium.

8. Procédé selon l'une quelconque des revendications précédentes, comprenant en outre l'opération qui consiste à former une couche de mouillage (16) entre ladite couche capuchon (17) et ladite couche de commande de conduction thermique (14, 15).

9. Procédé selon la revendication 8, où ladite couche de mouillage (16) est formée à partir de nitrure de silicium.

10. Procédé de recristallisation d'une région d'une couche conductrice non monocristalline, comprenant les opérations successives suivantes :

former une couche de commande de conduction thermique sur ladite couche non monocristalline, ladite couche de commande de conduction thermique ayant une partie à épaisseur accrue au-dessus de ladite région de la couche conductrice non monocristalline et définissant cette région ;

former une couche capuchon au-dessus de ladite couche de commande de conduction thermique ; et

irradier ladite couche capuchon à l'aide d'un faisceau d'énergie ayant une longueur d'onde absorbée par ladite couche capuchon de façon que ladite région de ladite couche non monocristalline fonde ; et

laisser refroidir ladite couche non monocristalline, de sorte qu'elle forme une région recristallisée exempte de frontière de grain dans ladite région définie.

11. Procédé selon la revendication 10, où la couche conductrice non monocristalline est faite de silicium polycristallin.

12. Procédé selon la revendication 10, où la couche conductrice non monocristalline est faite d'aluminium amorphe.

**Patentansprüche**

1. Verfahren zum Bilden einer Halbleitervorrichtung mit den folgenden sukzessiven Schritten:-
   Bilden eines nichtmonokristallinen Films (13) aus einem Halbleitermaterial auf einer Hauptoberfläche eines Isolators (12);
   Bilden einer Wärmeleitungssteuerschicht (14, 15) über dem nichtmonokristallinen Film (13), welche Wärme-Leitungs-Steuerschicht wenigstens einen Abschnitt (14) erhöhter Dicke hat, der einen Bereich begrenzt, in dem der nichtmonokristalline Film rekristallisiert werden soll;
   Bilden einer Deckschicht (17) auf der Wärmeleitungssteuerschicht (14, 15), und
   Bestrahlen der Deckschicht (17) mit einem Energiestrahl von Strahlungsenergie einer Wellenlänge, die durch die Deckschicht hinreichend absorbiert wird, um den definierten Bereich des nichtmonokristallinen Films (13) zu schmelzen; und
   Kühlenlassen der nichtmonokristallinen Schicht, und damit Bilden eines korngrenzenfreien rekristallisierten Bereichs (213) in dem definierten Bereich.

2. Verfahren nach Anspruch 1, bei dem die Wärmeleitung der Wärmeleitungssteuerschicht (14, 15) kleiner als jene der Deckschicht (17) ist.

3. Verfahren nach Anspruch 1 oder 2, bei dem der Isolator (12) ein Film ist, der auf einem Halbleitersubstrat (11) gebildet ist.

4. Verfahren nach Anspruch 3, bei dem das Substrat (11) aus Silizium besteht und der Isolator (12) ein Siliziumoxydfilm ist, der durch Oxidieren des Siliziumsubstrats gebildet ist.

5. Verfahren nach einem der vorhergehenden Ansprüche, ferner mit einem Schritt des Bildens einer Antireflexschicht auf der Deckschicht (17) vor der Bestrahlung der Deckschicht, welche Antireflexschicht die Reflexion des Strahlungsenergiestrahles reduziert, der auf die Oberfläche der energieabsorbierenden Deckschicht auffällt.

6. Verfahren nach einem der vorhergehenden Ansprüche, bei dem das Halbleitermaterial polykristallines Silizium ist, die Deckschicht (17) aus polykristallinem Silizium besteht und die Quelle des Energiestrahls ein Argonionenlaserstrahl ist.

7. Verfahren nach einem der vorhergehenden Ansprüche, bei dem die Wärmeleitungssteuerschicht (14, 15) eine Siliziumoxydschicht ist.

8. Verfahren nach einem der vorhergehenden Ansprüche, mit einem Schritt des Bildens einer Feuchtschicht (16) zwischen der Deckschicht (17) und der Wärmeleitungssteuerschicht (14, 15).

9. Verfahren nach Anspruch 8, bei dem die Feuchtschicht (16) aus Siliziumnitrid besteht.

10. Verfahren der Rekristallisierung eines Bereiches einer nichtmonokristallinen leitenden Schicht, mit den aufeinanderfolgenden Schritten:-
    Bilden einer Wärmeleitungssteuerschicht auf der monokristallinen Schicht, wobei die Wärmeleitungssteuerschicht einen Abschnitt erhöhter Dicke oberhalb des genannten Bereiches der nichtmonokristallinen leitenden Schicht, diesen Bereich begrenzend, hat;
    Bilden einer Deckschicht oberhalb der Wärmeleitungssteuerschicht; und
    Bestrahlen der Deckschicht mit einem Energiestrahl von einer Wellenlänge, die durch die Deckschicht absorbiert wird, so daß der genannte Bereich der nichtmonokristallinen Schicht geschmolzen wird;
    Abkühlenlassen der nichtmonokristallinen Schicht und damit Bilden eines korngrenzenfreien rekristallisierten Bereichs in dem begrenzten Bereich.

11. Verfahren nach Anspruch 10, bei dem die nichtmonokristalline leitende Schicht Polysilizium ist.

12. Verfahren nach Anspruch 10, bei dem die nichtmonokristalline leitende Schicht aus amorphem Silizium besteht.

FIG.1

FIG.2

FIG.3A

FIG.3B

FIG.3C

FIG.3D

FIG.3E

FIG.3F

FIG.3G